# DEMANDE DE BREVET EUROPEEN

(11) **EP 4 340 580 A1**
(43) Date de publication de la demande: **20.03.2024**
(21) Numéro de dépôt: 23197612.7
(22) Date de dépôt: 15.09.2023
(51) Int. Cl.: H10K 71/30, H10K 85/10, H10K 50/816, H10K 71/16, H10K 50/81, H10K 59/80, H10K 50/155

(54) **DIODE ÉLECTROLUMINESCENTE ORGANIQUE COMPRENANT UNE COUCHE D ANODE DE PEDOT**

(30) Priorité: 15.09.2022 FR 2209274
(71) Demandeur: Institut National Polytechnique de Toulouse, 31029 Toulouse Cedex 4 (FR); UNIVERSITE TOULOUSE III - PAUL SABATIER, 31062 Toulouse Cedex 9 (FR); Centre National de la Recherche Scientifique, 75016 Paris (FR)
(72) Inventeur: CAUSSAT, Brigitte, 31432 TOULOUSE CEDEX 4 (FR); BREIG, Benjamin, 31432 TOULOUSE CEDEX 4 (FR); VERGNES, Hugues, 31432 TOULOUSE CEDEX 4 (FR); VAHLAS, Constantin, 31030 TOULOUSE CEDEX 4 (FR); CAUSSE, Nicolas, 31030 TOULOUSE CEDEX 4 (FR); SAMELOR, Diane, 31030 TOULOUSE CEDEX 4 (FR); EL HOUSSEINY, Houssein, 31062 TOULOUSE CEDEX 9 (FR); RENAUD, Cédric, 31062 TOULOUSE CEDEX 9 (FR); TERNISIEN, Marc, 31062 TOULOUSE CEDEX 9 (FR); ZISSIS, Georges, 31062 TOULOUSE CEDEX 9 (FR)
(74) Mandataire: IPAZ

(57) **Abrégé**

La présente invention concerne une diode électroluminescente organique (bien connue sous l'anglicisme « *Organic Light Emitting Diode* » ou OLED) comprenant une couche de PEDOT dopé, monophasique ou obtenu par voie sèche oxydative, qui joue à la fois le rôle d'anode et de couche d'injection de trous, son procédé de fabrication, un dispositif opto-électronique comprenant une ou plusieurs desdites diodes électroluminescentes organiques, ainsi que l'utilisation de ladite diode électroluminescente organique ou dudit dispositif opto-électronique, comme moyen d'authentification ou de décoration.

## Description

La présente invention concerne une diode électroluminescente organique (bien connue sous l'anglicisme « *Organic Light Emitting Diode* » ou OLED) comprenant une couche de PEDOT dopé, monophasique ou obtenu par voie sèche oxydative, qui joue à la fois le rôle d'anode et de couche d'injection de trous, son procédé de fabrication, un dispositif optoélectronique comprenant une ou plusieurs desdites diodes électroluminescentes organiques, ainsi que l'utilisation de ladite diode électroluminescente organique ou dudit dispositif optoélectronique, comme moyen d'authentification ou de décoration.

Une diode électroluminescente organique est un dispositif basé sur le phénomène de l'électroluminescence permettant de transformer le courant électrique en lumière. L'OLED peut comporter un substrat, deux électrodes, l'une des électrodes, dite inférieure, généralement l'anode, étant associée au substrat et l'autre, dite supérieure, généralement la cathode, et un système électroluminescent organique intercalé entre lesdites électrodes, ledit système électroluminescent organique étant formé par un matériau électroluminescent organique (OLED monocouche) ou un empilement de matériaux électroluminescents organiques (OLED multicouches). L'OLED émet de la lumière par électroluminescence en utilisant l'énergie de recombinaison de trous injectés depuis l'anode et d'électrons injectés depuis la cathode. Dans le dispositif monocouche, un seul matériau organique est utilisé pour remplir les fonctions suivantes : l'injection des charges, le transport, la recombinaison, et l'émission de lumière. Une OLED monocouche est généralement constituée d'un film de semi-conducteur organique luminescent d'environ 100 nm d'épaisseur, inséré entre deux électrodes de natures chimiques différentes. L'anode injecte des trous et la cathode injecte des électrons. L'une de ces deux électrodes est transparente pour laisser passer la lumière émise. Très souvent, on utilise une anode en oxyde d'indium et d'étain (ITO) qui est un matériau conducteur, semi-transparent et possédant un travail de sortie compatible avec le rôle d'injecteur de trous. Quant à la cathode, elle est généralement constituée de métaux ou d'alliages (Ca, Mg, Mg/Ag, Al/Li ou LiF/AI) ayant un faible travail de sortie favorisant l'injection des électrons dans le semi-conducteur organique. Les matériaux électroluminescents utilisés font partie d'une des deux grandes familles : les polymères π-conjugués et les molécules de faible masse molaire.

Afin de renforcer la recombinaison des charges dans la couche émettrice et de diminuer les barrières d'injection, des couches ayant des fonctions spécifiques peuvent être introduites dans la structure de la diode telles que des couches pour l'injection des trous et des électrons (HIL pour « *Hole Injection Layer* » et EIL pour « *Electron Injection Layer »* respectivement) et/ou des couches pour le transport des trous et des électrons (HTL pour « *Hole Transfert Layer* » et ETL pour « *Electron Transfert Layer* » respectivement).

À titre d'exemple, la demande de brevet FR2897983A1 décrit une diode électroluminescente organique comprenant :
- une électrode inférieure et une électrode supérieure, l'une servant d'anode, l'autre de cathode, et une couche électroluminescente organique intercalée entre ces électrodes,
- une couche d'injection et de transport d'électrons en matériau organique semiconducteur dopé n, qui est en contact avec l'électrode servant de cathode et qui est intercalée entre cette électrode et ladite couche électroluminescente organique, et
- une couche d'injection et de transport de trous en matériau polymère conducteur, qui est en contact avec l'électrode servant d'anode et qui est intercalée entre cette électrode et ladite couche électroluminescente organique.

Une électrode constituée d'une couche d'ITO de 150 nm est utilisée en tant qu'anode et du PEDOT:PSS est mis en oeuvre en tant que couche d'injection et de transport de trous.

Le PEDOT:PSS est largement utilisé comme couche HIL/HTL dans les dispositifs optoélectroniques organiques parce qu'il est un bon conducteur de trous et qu'il peut être facilement déposé par voie liquide, notamment par enduction centrifuge (également bien connue selon l'anglicisme « *spin coating* ») ou par enduction par trempage (également bien connue selon l'anglicisme « *dip coating* »). En particulier, le complexe PEDOT:PSS est sous la forme d'une suspension aqueuse comprenant un mélange de deux polymères, le poly(3,4-éthylènedioxythiophène) (PEDOT) et le poly(styrène sulfonate) de sodium (PSS). Le PSS de par sa nature hydrophile stabilise la suspension aqueuse, et agit comme dopant pour exalter la conductivité électrique du mélange.

Cependant, la voie liquide de dépôt du PEDOT:PSS présente des inconvénients, tels qu'une conductivité électrique modérée (au plus 400 S/cm), la présence d'eau et de solvants qui peuvent ne pas être compatibles avec les substrats à revêtir et/ou les opérations menées ultérieurement comme dans le cas des OLEDs, le faible contrôle de l'épaisseur déposée, et/ou la non-conformité des dépôts, en particulier sur substrats complexes (i.e. substrats à motifs submicroniques). Par ailleurs, les propriétés hygroscopiques du PEDOT:PSS sont une source de dégradation prématurée des OLEDs. En effet, il a été démontré que la présence de résidus d'eau à l'interface ITO/organique, engendre la diffusion d'indium dans les couches organiques des dispositifs organiques. De plus, le caractère acide de certaines formulations utilisées pour déposer le PEDOT:PSS conduit à la dégradation de l'interface ITO/PEDOT:PSS.

Ces problèmes de dégradations liées au PEDOT:PSS, ont poussé au développement d'alternatives. Par exemple, l'une d'elles est basée sur l'utilisation de matériaux inorganiques. Réputés plus stables que le PEDOT:PSS, les couches d'oxydes métalliques, telles que l'oxyde de Molybdène (MoO₃), l'oxyde de tungstène (WO₃) ou encore les oxydes de vanadium (V₂O₃) ont été intégrés dans les OLEDs comme couches HIL/HTL. Cependant, l'inconvénient majeur de ces couches d'oxydes métalliques réside dans la dangerosité et la toxicité de ces oxydes métalliques.

Le matériau de l'électrode transparente conductrice joue également un rôle important dans les performances d'une OLED (propriétés intrinsèques de l'électrode telles que la transmittance optique, la conductivité électrique, l'état de surface tel que la rugosité). L'ITO est un matériau de référence dans le secteur des électrodes transparentes en raison de ses excellentes propriétés optoélectroniques et de sa robustesse. Il possède une très bonne conductivité (jusqu'à 10⁴ S/cm) avec une résistance surfacique de l'ordre de 10 Ω/carré et une excellente transmittance optique dans le visible (entre 85 et 95% en particulier dans la plage 380 nm et 800 nm). Cependant, plusieurs problèmes se posent, notamment économiques et pratiques. En effet, l'électrode d'ITO comporte de l'indium, dont le marché a explosé au même moment que celui des écrans à cristaux liquides (LCD). Ses ressources principales se trouvent principalement en Chine, maintenant un niveau élevé du cours du matériau brut, et la réserve mondiale ne cesse de diminuer. De plus, son procédé de dépôt est lourd et coûteux, en plus d'être principalement réalisé sur des substrats en verre. En effet, l'ITO est fragile et cassant sur substrat souple, et par conséquent peu flexible. C'est pourquoi la recherche de matériaux alternatifs est lancée depuis plusieurs années.

D'autres oxydes conducteurs transparents tels que l'oxyde d'étain dopé au fluor (FTO) ou de l'oxyde de zinc dopé à l'aluminium ont également été proposés. Cependant, ils possèdent en général un rapport conductivité électrique-transparence moindre et une rugosité en surface plus élevée. De plus, ils sont en général plus instables face à l'humidité lorsque les couches sont inférieures à 100 nm d'épaisseur. Par ailleurs, la méthode la plus répandue pour réaliser des films d'oxydes conducteurs transparents est le dépôt par pulvérisation cathodique. Cette technologie fonctionne sous vide secondaire, ce qui rend la fabrication de couches minces d'oxydes conducteurs transparents souvent coûteuse en matériaux et en énergie.

Des nanomatériaux à base de carbone ont également été proposés, tels que les nanotubes de carbone ou le graphène. Malgré leurs excellentes propriétés électriques, optiques et mécaniques, les nanotubes de carbone peinent encore à être présents dans des applications commercialisables en raison des impuretés présentes lors de leur fabrication ainsi que la large distribution de leurs dimensions. La conductivité électrique des couches est assurée par le seuil de percolation des nanotubes de carbone. Pour des applications dans les OLEDs, un point critique de ces films est la rugosité de surface qui reste plus élevée que celle des films d'ITO. Concernant le graphène, sa production à l'échelle industrielle est active depuis quelques années. Toutefois, le manque de reproductibilité des propriétés optoélectroniques des films ne permet pas encore de l'inclure dans des procédés commerciaux.

Des nanostructures métalliques telles que les nanoparticules et les nanofils métalliques ont également été décrites. Toutefois, de par leur taille et leur forme sphérique, les nanoparticules de métal sont peu utilisées en tant qu'électrode transparente puisqu'elles doivent être assemblées d'une certaine manière ou associées à d'autres composés, afin de montrer des performances électriques et optiques intéressantes. Les nanofils peuvent être à base de cuivre ou d'argent. De par leurs propriétés optoélectroniques qui permettent un bon compromis entre conductivité électrique et transmittance, les électrodes à base de nanofils d'argent sont déjà commercialisées par Cambrios sous la forme de films conducteurs transparents intégrés dans des écrans tactiles. Néanmoins, ces films présentent un handicap non négligeable pour des applications d'affichage. En effet, la géométrie des nanofils conduit à un aspect laiteux des écrans. Cet aspect visuel limite ainsi des applications dans les OLEDs. Par ailleurs, tout comme les nanotubes de carbone, la principale limitation à l'utilisation de réseaux de nanofils en tant qu'électrode, est la rugosité. En effet, les nanofils dressés peuvent entraîner des court-circuits ou des courants de fuite dans les dispositifs multicouches. D'autre part, la stabilité des électrodes de nanofils reste également problématique puisque lors d'une exposition prolongée à des conditions de température et d'humidité élevées, ou après avoir été soumise à un courant électrique continu, la conductivité de l'électrode se dégrade.

Des polymères conducteurs ont également été proposés tels que des polythiophènes. Le polymère conducteur le plus utilisé en tant qu'électrode transparente dans le domaine de l'électronique organique est le PEDOT:PSS tel que décrit plus haut en tant que couche HIL/TIL. Cependant, plusieurs problèmes se posent, dont la conductivité qui reste en-deçà d'autres alternatives à transparence égale, et également l'hygroscopie et l'acidité de ce matériau. Le groupement PSS est négativement chargé et rend alors le milieu très acide qui, couplé à l'hygroscopie, laisse les films de PEDOT:PSS relativement instables pour une utilisation prolongée dans des OLEDs. La stabilité peut cependant être améliorée à l'aide d'additifs. Par ailleurs, il est également possible de former des couches composites avec ce polymère et des nanomatériaux à base de carbone ou de métaux. Une modification chimique des nanomatériaux à associer avec le PEDOT:PSS a aussi été étudiée, toujours dans le but d'augmenter la conductivité et la robustesse de l'électrode.

Le but de la présente invention est par conséquent de pallier les inconvénients de l'art antérieur, et notamment de fournir une diode électroluminescente organique (OLED) plus économique et écologique, tout en garantissant de bonnes performances en termes de luminance, transmittance, conductivité électrique, stabilité, et/ou rugosité.

L'invention a pour premier objet une diode électroluminescente organique, caractérisée en ce qu'elle comprend, successivement, dans l'ordre suivant :
- un substrat transparent non conducteur,
- une couche d'anode transparente conductrice comprenant du PEDOT dopé monophasique ou du PEDOT dopé obtenu par voie sèche oxydative,
- un système électroluminescent organique, et
- une couche de cathode.

La diode conforme au premier objet de l'invention met en oeuvre une couche comprenant du PEDOT dopé obtenu par voie sèche oxydative ou du PEDOT dopé monophasique en tant que couche d'anode. Cela permet d'une part, de s'affranchir de l'utilisation de complexes à base de PEDOT ayant les désavantages précités tels que le PEDOT:PSS ou de l'utilisation d'ITO ; et d'autre part de réduire les coûts et l'empreinte environnementale et énergétique des OLEDs, pour mieux répondre aux besoins du marché actuel (aéronautique, automobile, éclairage urbain, ···), tout en garantissant de bonnes performances en termes de luminance, transmittance, conductivité électrique, stabilité, et/ou rugosité.

En particulier, la diode électroluminescente organique de l'invention est plus économique et écologique, tout en garantissant de bonnes performances en termes de luminance. Par ailleurs, la couche d'anode transparente conductrice comprenant du PEDOT dopé mise en oeuvre dans ladite diode s'avère être une couche permettant une meilleure extraction de lumière (on parle aussi d'avoir une meilleure couche "diffusante" de lumière). Elle favorise l'extraction de la lumière (light out-coupling) des couches organiques (système électroluminescent organique) vers le substrat transparent non conducteur, notamment de par sa transparence mais également son indice de réfraction le plus proche possible de l'indice de réfraction des couches organiques et du substrat. Les pertes optiques sont par conséquent minimisées.

La diode conforme au premier objet de l'invention est un dispositif d'émission de la lumière. En d'autres termes, un tel dispositif est différent d'un dispositif d'absorption de la lumière tel qu'un dispositif photovoltaïque.

La diode conforme au premier objet de l'invention émet de préférence de la lumière dans les longueurs d'onde allant de 400 nm à 800 nm environ.

### Substrat transparent non conducteur

Le substrat (ou support) transparent non conducteur est transparent.

Dans la présente invention, on entend par « substrat transparent », un substrat transmettant au moins une partie de la lumière incidente (ou rayon lumineux incident) avec très peu voire sans dispersion. De préférence, le substrat est transparent dans la gamme de longueurs d'onde visible. Le substrat transparent présente une transmission lumineuse (transmittance) d'au moins 70 % environ, et de façon particulièrement préférée d'au moins 80 % environ. La transmission lumineuse est la quantité de lumière que laisse passer le substrat transparent à partir d'un rayon lumineux incident. La transmission lumineuse visible est la quantité de lumière visible, correspondant aux ondes électromagnétiques dont la longueur d'onde correspond au spectre visible, soit entre les longueurs d'onde 380 et 800 nm environ (bornes comprises), que laisse passer le substrat à partir d'un rayon lumineux incident.

La transmission lumineuse ou transmittance peut être déterminée à l'aide d'un spectromètre Perkin Elmer Lambda 35 UV/Vis.

Elle est de préférence mesurée à 550 nm environ.

Le substrat transparent est non conducteur.

Dans la présente invention, on entend par « substrat non conducteur », un substrat ayant une résistivité ou résistance surfacique d'au moins 10⁴ ohm/carré environ, et de façon particulièrement préférée d'au moins 10⁶ ohm/carré environ.

La résistivité peut être déterminée avec un appareil de mesure quatre pointes ou par la méthode de Van der Pauw.

Dans la présente invention, on entend par « substrat non conducteur », un substrat ayant une conductivité électrique d'au plus 10⁻⁶ S/cm environ, et de façon particulièrement préférée d'au plus 10⁻⁸ S/cm environ.

La conductivité électrique peut être déterminée avec un appareil de mesure quatre pointes ou par la méthode de Van der Pauw associée à une mesure d'épaisseur par profilométrie ou Microscopie à Force Atomique.

Le substrat transparent non conducteur peut comprendre (ou être constituée d') un matériau choisi parmi les matériaux inorganiques à base d'oxyde de silicium, les matériaux inorganiques à base d'alumine tels que les matériaux céramiques à base d'alumine, les matériaux polymères, les matériaux cellulosiques, et les matières textiles.

Parmi les matériaux polymères, on peut citer les polyacrylates tels que le polyméthacrylate de méthyle, les polyesters tels que le polyéthylène téréphtalate ou l'acide polylactique, les parylènes tels que le parylène de type C (parylène-C), et les polyimides.

Parmi les matériaux inorganiques à base d'oxyde de silicium, on peut citer le verre, ou le quartz.

Parmi les matériau céramiques à base d'alumine, on peut citer l'alumine polycristalline (Al₂O₃), le saphir, le nitrure d'aluminium (ALN), l'oxynitrure d'aluminium (ALON), ou le spinelle (MgAl₂O₄).

Parmi les matériaux cellulosiques, on peut citer le papier, le carton, le papier cartonné, et les matériaux à base de cellulose.

Parmi les matières textiles, on peut citer les fibres naturelles ou synthétiques, telles que le lin, le coton, ou les fibres polymères.

De préférence, le substrat transparent non conducteur comprend du (ou est constituée de) verre, quartz, polyméthacrylate de méthyle, polyéthylène téréphtalate, papier, matière textile, acide polylactique, parylène-C, ou alumine polycristalline.

Le substrat transparent non conducteur peut être un substrat transparent non conducteur traité, i.e. ayant subi un ou plusieurs traitements de surface, en particulier afin d'éviter sa contamination à l'oxygène et/ou à l'eau. Dans ce mode de réalisation, le substrat transparent non conducteur traité comprend une ou plusieurs couches barrière(s) (à la contamination).

La ou les couches barrière peuvent être choisies parmi une couche de SiO₂, une couche de Al₂O₃, une couche de parylène-C, une couche de nitrure de silicium (SiNₓ), et un de leurs mélanges.

Chacune des couches barrières peut avoir une épaisseur allant de 100 nm à 1000 nm environ.

La couche de Al₂O₃ est préférentiellement déposée par dépôt de couche atomique ou ALD (bien connu sous l'anglicisme « *atomic layer déposition* ») ou par pulvérisation cathodique.

La couche de parylène-C est préférentiellement déposée par dépôt chimique en phase vapeur ou CVD (bien connu sous l'anglicisme « *chemical vapor deposition* »)

La couche de SiO₂ ou de SiNₓ est préférentiellement déposée par pulvérisation cathodique ou par ALD.

Les couches de Al₂O₃, de SiO₂ ou de SiNₓ peuvent avoir chacune une épaisseur allant de 15 nm à 50 nm environ.

La couche de parylène-C peut avoir une épaisseur allant de 100 nm à 1000 nm environ.

Le substrat transparent non conducteur (incluant la ou les couches barrières si elles existent) peut avoir une épaisseur allant de 0,1 à 10 mm environ.

Le substrat transparent non conducteur peut être poreux ou non poreux, et de préférence non poreux.

Le substrat transparent non conducteur ne comprend pas de préférence de matériaux carbonés conducteurs tels que du graphène, des nanotubes ou fibres de carbone, ou des matériaux métalliques conducteurs tels que des particules, nanoparticules ou nanofils d'argent.

Le substrat transparent non conducteur peut être rigide ou flexible, plat ou incurvé.

Le substrat transparent non conducteur a de préférence un indice de réfraction allant de 1,35 à 1,65. Il est choisi de façon particulièrement préférée le plus proche possible de celui de l'anode transparente conductrice.

### Système électroluminescent organique

Dans l'invention, le terme « système électroluminescent » signifie que le système émet de la lumière en réponse à un courant électrique qui le traverse, ou à un champ électrique (i.e. un fort champ électrique, en particulier allant de 2 MV.m⁻¹ à 230 MV.m⁻¹). Le système émet de la lumière de préférence dans la gamme de longueurs d'onde allant de 380 à 800 nm environ.

En d'autres termes, le système électroluminescent ne comprend pas de couche(s) absorbante(s) comme c'est le cas dans les dispositifs d'absorption de la lumière (tels que des dispositifs photovoltaïques). La présence de telles couches absorbantes empêcherait alors l'émission de la lumière recherchée dans un dispositif OLED.

Le système électroluminescent organique caractérise l'OLED, il est notamment intercalé entre les électrodes, i.e. entre la couche d'anode et la couche de cathode.

Le système électroluminescent est organique. En d'autres termes, il comprend au moins des atomes de carbone liés de manière covalente à des atomes d'hydrogène. En d'autres termes, le système électroluminescent organique comprend essentiellement des composés organiques et/ou des composés organométalliques. Le système électroluminescent ne comprend pas de préférence de composé(s) inorganique(s), i.e. de composé(s) exempt(s) d'atomes de carbone liés de manière covalente à des atomes d'hydrogène.

Le système électroluminescent organique comprend de préférence au moins un matériau transporteur de trous (e.g. matériau de type p) et au moins un matériau transporteur d'électrons (e.g. matériau de type n).

Le matériau transporteur de trous est bien connu de l'homme du métier et est généralement défini comme un matériau qui conduit plus facilement des charges positives (trous) que des charges négatives (électrons). En particulier, il est capable de transporter des trous vers une zone d'émission.

Le matériau transporteur d'électrons est bien connu de l'homme du métier et est généralement défini comme un matériau qui conduit plus facilement des charges négatives (électrons) que des charges positives (trous). En particulier, il est capable de transporter des électrons vers une zone d'émission.

Le système électroluminescent organique a de préférence une épaisseur allant de 100 à 250 nm environ.

Le système électroluminescent organique peut être sous la forme d'une couche ou de plusieurs couches empilées les unes sur les autres. On parle alors de système monocouche ou multicouche respectivement.

Chacune des couches du système électroluminescent a de préférence un indice de réfraction allant de 1,4 à 1,7. Il est choisi de façon particulièrement préférée le plus proche possible de celui de l'anode transparente conductrice.

Le système électroluminescent organique est de préférence au moins en partie en contact physique direct avec la couche de cathode.

En d'autres termes, dans ce mode de réalisation préféré, au moins une partie de la surface du système électroluminescent organique est en contact physique direct avec la surface de la couche de cathode. Cela signifie que la couche de cathode est déposée directement sur au moins une partie, et de préférence la totalité de la surface dudit du système électroluminescent organique. À ce titre, la diode électroluminescente organique de l'invention ne comprend pas de couche(s) additionnelle(s) intercalée(s) entre la couche de cathode et le système électroluminescent organique.

La couche d'anode transparente conductrice comprenant du PEDOT dopé monophasique ou du PEDOT dopé obtenu par voie sèche oxydative est de préférence au moins en partie en contact physique direct avec le système électroluminescent organique.

En d'autres termes, dans ce mode de réalisation préféré, au moins une partie de la surface de la couche d'anode transparente conductrice comprenant du PEDOT dopé monophasique ou du PEDOT dopé obtenu par voie sèche oxydative est en contact physique direct avec la surface du système électroluminescent organique. Cela signifie que le système électroluminescent organique est déposé directement sur au moins une partie, et de préférence la totalité de la surface de ladite couche d'anode transparente conductrice comprenant du PEDOT dopé monophasique ou du PEDOT dopé obtenu par voie sèche oxydative. À ce titre, la diode électroluminescente organique de l'invention ne comprend pas de couche(s) additionnelle(s) intercalée(s) entre le système électroluminescent organique et la couche d'anode transparente conductrice comprenant du PEDOT dopé monophasique ou du PEDOT dopé obtenu par voie sèche oxydative.

Le système électroluminescent organique est de préférence multicouche, de façon particulièrement préférée bicouche ou tricouche, et de façon plus particulièrement préférée bicouche.

Dans le cas d'un système électroluminescent organique monocouche, le matériau transporteur de trous et le matériau transporteur d'électrons peuvent être un seul et même matériau.

Le système électroluminescent organique multicouche comprend de préférence :
- au moins une couche de transport de trous, préférentiellement au moins en partie en contact physique direct avec la couche d'anode transparente conductrice comprenant du PEDOT dopé monophasique ou du PEDOT dopé obtenu par voie sèche oxydative ; et
- au moins une couche de transport d'électrons, préférentiellement au moins en partie en contact physique direct avec la couche de cathode.

La couche de transport de trous a de préférence une épaisseur allant de 35 à 60 nm environ.

La couche de transport de trous peut comprendre (ou être constitué d') au moins un composé organique ou organométallique, en tant que matériau transporteur de trous, choisi parmi le *N*,*N*'-Di(1-naphthyl)-*N*,*N*'-diphenyl-(1,1'-biphenyl)-4,4'-diamine (NPD ou NPB), 4,4',4"-tris[phényl(m-tolyl)amino]triphénylamine (m-MTDATA), 3,3'-Di(9*H*-carbazol-9-yl)-1,1'-biphényl (MCBP), tris(4-carbazoyl-9-ylphényl)amine (TCTA), le 1,1-bis[(di-4-tolylamino)phényl]cyclohexane (TAPC), et le phthalocyanine de cuivre (II) (CuPc).

La couche de transport d'électrons a de préférence une épaisseur allant de 20 à 80 nm environ.

La couche de transport d'électrons peut comprendre (ou être constitué d') au moins un composé organique ou organométallique, en tant que matériau transporteur d'électrons, choisi parmi le tris-(8-hydroxyquinoline)aluminum (AlQ₃), bathocuproine (BCP), bathophénanthroline (Bphen), 2,2',2"-(1,3,5-benzinétriyl)-tris(1-phényl-1*H-*benzimidazole) (TPBi), bis(8-hydroxy-2-méthylquinoline)-(4-phénylphénoxy)aluminium (Balq), et le 3-(biphényl-4-yl)-5-(4-tertbutylphényl)-4-phényl-4H-1,2,4-triazole (TAZ).

Le système électroluminescent organique comprend généralement une zone d'émission soit dans la couche de transport de trous, soit dans la couche de transport d'électrons, soit à l'interface entre les deux couches.

Le système électroluminescent organique multicouche peut comprendre en outre une couche d'émission (bien connue selon l'anglicisme « *Emission Layer* » ou EML), interposée entre les couches de transport de trous et de transport d'électrons, notamment pour optimiser l'émission (couleur, rendement lumineux, etc...).

### La couche de cathode

La couche de cathode peut comprendre (ou être constituée d') un métal choisi parmi le baryum, le magnésium, l'argent, le calcium, l'aluminium, et l'aluminium associé à une couche de fluorure de lithium.

Le calcium est préféré, notamment en raison de son faible travail de sortie (-2,9 eV).

La couche de cathode peut avoir une épaisseur allant de 80 à 130 nm environ.

La couche de cathode est notamment génératrice de charges négatives.

La couche de cathode présente de préférence un travail de sortie inférieur à -4 eV environ.

Dans la diode de l'invention, la couche de cathode est connectée électriquement à la couche d'anode.

### La couche d'anode comprenant du PEDOT

La diode électroluminescente organique de l'invention comprend une couche d'anode transparente conductrice comprenant du PEDOT dopé monophasique ou du PEDOT dopé obtenu par voie sèche oxydative.

La couche d'anode est transparente.

Dans la présente invention, on entend par « couche d'anode transparente », une couche transmettant au moins une partie de la lumière incidente (ou rayon lumineux incident) avec très peu voire sans dispersion. De préférence, la couche d'anode transparente est transparente dans la gamme de longueurs d'onde UV-visible. La couche transparente présente une transmission lumineuse (transmittance) d'au moins 80% environ, et de façon particulièrement préférée d'au moins 90% environ. La transmission lumineuse est la quantité de lumière que laisse passer la couche transparente à partir d'un rayon lumineux incident. La transmission lumineuse UV-visible est la quantité de lumière UV-visible, correspondant aux ondes électromagnétiques dont la longueur d'onde correspond au spectre UV-visible, soit entre les longueurs d'onde 100 et 800 nm environ (bornes comprises), que laisse passer la couche transparente à partir d'un rayon lumineux incident.

La transmission lumineuse ou transmittance peut être déterminée à l'aide d'un spectromètre Perkin Elmer Lambda 35 UV/Vis.

Elle est de préférence mesurée à 550 nm environ.

La couche d'anode est conductrice. La couche d'anode est notamment génératrice de charges positives.

Dans la présente invention, on entend par « couche d'anode conductrice », une couche ayant une résistivité ou résistance surfacique d'au plus 500 ohm/carré environ, et de façon particulièrement préférée d'au plus 20 ohm/carré environ.

La résistivité peut être déterminée avec un appareil de mesure quatre pointes ou par la méthode de Van der Pauw.

Dans la présente invention, on entend par « couche d'anode conductrice », une couche ayant une conductivité électrique d'au moins 500 S/cm environ, et de façon particulièrement préférée d'au moins 800 S/cm environ.

La conductivité électrique peut être déterminée avec un appareil de mesure quatre pointes ou par la méthode de Van der Pauw associée à une mesure d'épaisseur par profilométrie ou Microscopie à Force Atomique.

La couche d'anode de l'invention présente de préférence un travail de sortie supérieur à -4,8 eV environ. Cela permet ainsi de favoriser le transfert des charges positives vers le niveau énergétique de transport des charges positives dans les matériaux organiques du système électroluminescent organique, appelé « HOMO » (bien connu sous l'anglicisme « *Highest Occupied Molecular Orbital* »)*.*

La couche d'anode de la diode de l'invention a pour fonction de générer et d'injecter les charges positives (les trous) vers le système électroluminescent organique. Elle joue à la fois le rôle d'anode et de couche d'injection de trous.

La couche d'anode transparente conductrice comprend du PEDOT dopé monophasique ou du PEDOT dopé obtenu par voie sèche oxydative.

La couche d'anode de l'invention est de préférence une couche flexible.

Le PEDOT est du poly(3,4-éthylènedioxythiophène).

Il est préférentiellement dopé avec des anions choisis parmi les halogénures tels que les chlorures, bromures, iodures ou fluorures.

Les anions jouant le rôle de dopant dans le PEDOT sont de préférence non polymériques, i.e. ils ne comprennent pas de chaine polymère.

Les halogénures tels que les chlorures sont particulièrement préférés.

La couche d'anode peut avoir une épaisseur allant de 8 à 80 nm environ, et de préférence allant de 30 à 50 nm.

La couche d'anode a de préférence une rugosité Rq ou écart moyen quadratique d'au plus 10 nm environ en moyenne quadratique (bien connu selon l'anglicisme « *Roots Mean Square* » ou RMS), et de façon particulièrement préférée d'au plus 5 nm environ en RMS.

Si la rugosité est trop élevée, des chemins de conduction peuvent apparaître entre les deux électrodes créant ainsi des court-circuits qui empêchent le bon fonctionnement de l'OLED.

La rugosité de la couche d'anode peut être mesurée à l'aide d'un dispositif avec ou sans contact, tel qu'un profilomètre à palpeur, un dispositif à coupe optique ou un microscope à force atomique.

La rugosité est de préférence mesurée à l'aide d'un dispositif à force atomique tel qu'un microscope à force atomique (ou AFM pour « *atomic force microscope* »)*.*

L'écart moyen quadratique de rugosité Rq est défini dans la norme internationale NF EN ISO 4287.

Selon une forme de réalisation de l'invention, la couche d'anode comprend au moins 90% en masse de PEDOT dopé monophasique ou obtenu par voie sèche oxydative, de façon particulièrement préférée au moins 95% en masse de PEDOT dopé monophasique ou obtenu par voie sèche oxydative, par rapport à la masse totale de la couche d'anode, et de façon plus particulièrement préférée est constituée de PEDOT dopé monophasique ou obtenu par voie sèche oxydative.

Selon une forme de réalisation particulièrement préférée de l'invention, le substrat transparent non conducteur est au moins en partie en contact physique direct avec la couche d'anode transparente conductrice.

En d'autres termes, dans ce mode de réalisation particulièrement préféré, la couche d'anode transparente conductrice est déposée directement sur au moins une partie, et de préférence la totalité de la surface dudit substrat transparent non conducteur. À ce titre, la diode électroluminescente organique de l'invention ne comprend pas de couche(s) additionnelle(s) intercalée(s) entre la couche d'anode transparente conductrice et le substrat transparent non conducteur (traité ou non traité). Cela signifie également que la diode électroluminescente organique ne comprend pas de couche(s) d'anode transparente(s) conductrice(s) autre(s) que celle de l'invention comprenant du PEDOT dopé monophasique ou obtenu par voie sèche oxydative.

De préférence, la diode électroluminescente organique ne comprend pas de couche(s) d'injection de trous autre(s) que la couche d'anode transparente conductrice comprenant du PEDOT dopé monophasique ou obtenu par voie sèche oxydative.

La voie sèche oxydative ou le caractère monophasique du PEDOT dopé permet de remplacer certains des matériaux constitutifs actuels de diodes électroluminescentes (complexes de PEDOT tels que le PEDOT:PSS, ITO, autres anodes d'oxydes métalliques, graphène, etc...) qui sont néfastes pour l'environnement, peu performants, et/ou présentent un coût trop élevé ; et de fournir un couche d'anode sans eau, ni solvant, d'épaisseur contrôlée, et uniforme, sur tout type de substrat rigide ou flexible, et en particulier sur substrats complexes (i.e. substrats à motifs submicroniques). Par ailleurs, cela permet d'éviter l'utilisation d'anodes rigides telles que l'ITO et d'ouvrir la voie à la fabrication d'OLEDs sur substrats souples et légers (plastique, papier, tissu, ...), laissant augurer de nouvelles applications (bandages luminescents pour la photothérapie, papiers avec marqueurs infalsifiables, tissus éclairants, ...).

La voie sèche oxydative signifie que le PEDOT dopé est obtenu ou préparé dans un milieu sec, i.e. exempt de liquide. En d'autres termes, la voie sèche n'est pas limitée à la polymérisation « proprement dite » du monomère 3,4-éthylènedioxythiophène (EDOT) pour former le PEDOT, mais concerne aussi bien la polymérisation (sèche) du monomère EDOT ; que l'état (sec) des réactifs mis en oeuvre dans la préparation du PEDOT dopé. La voie sèche doit par exemple être distinguée de la polymérisation en phase vapeur, également connue sous l'anglicisme « *vaporphase polymerization* » ou VPP, qui implique une étape d'enduction centrifuge d'une solution liquide d'un agent oxydant suivie par son exposition à un flux continu de vapeurs d'EDOT.

Comme expliqué précédemment, les méthodes dites « humides » ou liquides s'avèrent parfaitement adaptées à la production de masse, mais l'un des points critiques reste l'élimination des solvants lors de l'élaboration des couches. En effet, la présence de résidus de solvant dans les couches est responsable de la formation de défauts (tels que les trous ponctuels ou « *pinhole* »). Ceux-ci sont causés par des zones de démouillage dans la couche. Ces défauts entraînent une dégradation prématurée des OLEDs. La voie sèche oxydative permet notamment d'éviter la formation de ce type de défauts.

La voie sèche est dite « oxydative » en ce qu'elle met en oeuvre au moins un agent oxydant.

La voie sèche oxydative peut être choisie parmi le dépôt chimique oxydatif en phase vapeur (également connu sous l'anglicisme « *oxidative Chemical Vapor Deposition* » ou oCVD) et le dépôt oxydatif d'une couche moléculaire (également connu sous l'anglicisme « *oxidative Molecular Layer Deposition* » ou oMLD).

Dans un mode de réalisation préféré, le PEDOT dopé de la couche d'anode transparente conductrice est obtenu à partir du monomère EDOT et d'au moins un agent oxydant, lesdits monomère EDOT et agent oxydant étant des espèces gazeuses (i.e. sous la forme gazeuse).

L'agent oxydant peut être choisi parmi CuCl₂, FeCl₃, FeBr₃, I₂, POBr₃, GeCl₄, ShI₃, Br₂, SbF₅, H₂SO₄, SbCl₅, TiCl₄, POCl₃, SO₂Cl₂, CrO₂Cl₂, S₂Cl, O(CH₃)₃SbCl₆, VCl₄, MoCl₅, VOCl₃, BF₃, (CH₃(CH₂)₃)₂O.BF₃, (C₂H₅)₃O(BF₄), et BF₃.O(C₂H₅)₂.

FeCl₃, SbCl₅, et VOCl₃ sont préférés. En particulier, FeCl₃ présente une faible toxicité et un coût modeste.

L'oCVD et l'oMLD sont des procédés en une seule étape, purement en phase gazeuse, et donc ne génèrent aucun problème de compatibilité substrat-solvant ou de contamination d'un dépôt par un liquide. Dans ces procédés, l'agent oxydant sert à la fois de promoteur de la polymérisation du monomère EDOT et d'agent dopant pour former le polymère conducteur.

L'oCVD et l'oMLD diffèrent en ce que l'oCVD consiste à envoyer simultanément dans un réacteur les espèces gazeuses précitées et l'oMLD consiste à envoyer de manière séquentielle dans un réacteur les espèces gazeuses précitées. Dans les deux cas, une couche mince de PEDOT dopé est formée sur le ou les substrats, en particulier placé(s) dans un réacteur.

Dans un mode de réalisation préféré, le PEDOT dopé obtenu par voie sèche oxydative est un PEDOT dopé monophasique.

Dans l'invention, le terme « PEDOT dopé monophasique » signifie que le PEDOT dopé (i.e. associé au dopant) forme une seule phase. En d'autres termes, il n'est pas sous la forme de plusieurs phases tels que les complexes à base de PEDOT de type PEDOT:PSS ou PEDOT:PTS. Le caractère monophasique ou multiphasique peut être facilement déterminé par spectroscopie vibrationnelle (Raman ou FTIR).

Dans un mode de réalisation préféré, le PEDOT dopé monophasique est obtenu par voie sèche oxydative. La voie sèche oxydative est telle que définie dans l'invention.

Le procédé d'obtention de la couche de PEDOT dopé par voie sèche oxydative est explicité en détail dans le troisième objet de l'invention.

L'invention a pour deuxième objet un dispositif optoélectronique, caractérisé en ce qu'il comprend une pluralité de diodes électroluminescentes organiques, au moins une des diodes électroluminescentes organiques de ladite pluralité étant conforme au premier objet de l'invention.

De préférence, la pluralité de diodes électroluminescentes comprend successivement, dans l'ordre suivant :
- un substrat transparent non conducteur,
- une ou plusieurs couche(s) d'anode transparente(s) conductrice(s) comprenant du PEDOT dopé monophasique ou du PEDOT dopé obtenu par voie sèche oxydative,
- un système électroluminescent organique, et
- plusieurs couches de cathode.

Le substrat transparent non conducteur, la ou les couche(s) d'anode transparente(s) conductrice(s) comprenant du PEDOT dopé monophasique ou du PEDOT dopé obtenu par voie sèche oxydative, le système électroluminescent organique, et les couches de cathode sont tels que définis dans le premier objet de l'invention.

Dans un mode de réalisation particulier, le dispositif optoélectronique comprend une pluralité de diodes électroluminescentes organiques, chacune des diodes électroluminescentes organiques de ladite pluralité étant conforme au premier objet de l'invention.

Le dispositif optoélectronique peut être un panneau d'éclairage ou d'affichage d'images.

Les couches de cathode sont de préférence sur un même plan, qui est parallèle au plan formé par le système électroluminescent organique.

Le système électroluminescent organique est de préférence au moins en partie en contact physique direct avec les couches de cathode.

En d'autres termes, dans ce mode de réalisation préféré, au moins une partie de la surface du système électroluminescent organique est en contact physique direct avec la surface des couches de cathode. Cela signifie que les couches de cathode sont déposées directement sur au moins une partie, et de préférence la totalité de la surface du système électroluminescent organique. À ce titre, la diode électroluminescente organique de l'invention ne comprend pas de couche(s) additionnelle(s) intercalée(s) entre les couches de cathode et le système électroluminescent organique.

Les couches d'anode transparentes conductrices comprenant du PEDOT dopé monophasique ou du PEDOT dopé obtenu par voie sèche oxydative (lorsqu'il y en a plusieurs) sont de préférence sur un même plan, qui est parallèle au plan formé par le système électroluminescent organique.

La ou les couches d'anode transparentes conductrices comprenant du PEDOT dopé monophasique ou du PEDOT dopé obtenu par voie sèche oxydative sont de préférence au moins en partie en contact physique direct avec le système électroluminescent organique.

En d'autres termes, dans ce mode de réalisation préféré, au moins une partie de la surface des couches d'anode transparentes conductrices comprenant du PEDOT dopé monophasique ou du PEDOT dopé obtenu par voie sèche oxydative est en contact physique direct avec la surface du système électroluminescent organique. Cela signifie que le système électroluminescent organique est déposé directement sur au moins une partie, et de préférence la totalité de la surface des couches d'anode transparentes conductrices comprenant du PEDOT dopé monophasique ou du PEDOT dopé obtenu par voie sèche oxydative. À ce titre, la diode électroluminescente organique de l'invention ne comprend pas de couche(s) additionnelle(s) intercalée(s) entre le système électroluminescent organique et les couches d'anode transparentes conductrices comprenant du PEDOT dopé monophasique ou du PEDOT dopé obtenu par voie sèche oxydative.

Selon une forme de réalisation particulièrement préférée de l'invention, le substrat transparent non conducteur est au moins en partie en contact physique direct avec la ou les couches d'anode transparentes conductrices comprenant du PEDOT dopé monophasique ou du PEDOT dopé obtenu par voie sèche oxydative.

En d'autres termes, dans ce mode de réalisation préféré, cela signifie que les couches d'anode transparentes conductrices sont déposées directement sur au moins une partie, et de préférence la totalité de la surface dudit substrat transparent non conducteur. À ce titre, la diode électroluminescente organique de l'invention ne comprend pas de couche(s) additionnelle(s) intercalée(s) entre les couches d'anode transparentes conductrices et le substrat transparent non conducteur (traité ou non traité). Cela signifie également que la diode électroluminescente organique ne comprend pas de couche(s) d'anode transparente(s) conductrice(s) autre(s) que celles de l'invention comprenant du PEDOT dopé monophasique ou obtenu par voie sèche oxydative.

De préférence, la diode électroluminescente organique ne comprend pas de couche(s) d'injection de trous autre(s) que les couches d'anode transparentes conductrices comprenant du PEDOT dopé monophasique ou obtenu par voie sèche oxydative.

### Procédé de fabrication d'une diode électroluminescente

L'invention a pour troisième objet un procédé de fabrication d'une diode électroluminescente conforme au premier objet de l'invention, caractérisé en ce qu'il comprend au moins une étape i) de dépôt d'une couche d'anode transparente conductrice comprenant du PEDOT dopé sur un substrat transparent non conducteur, ladite étape i) étant effectuée par voie sèche oxydative.

Le substrat transparent non conducteur et la couche d'anode transparente conductrice sont tels que définis dans le premier objet de l'invention.

Le procédé de l'invention est simple, facile à mettre en oeuvre et permet de produire des couches de PEDOT dopé d'épaisseur contrôlable à quelques nanomètres près, uniformes sur plusieurs dizaines de cm², conformes sur substrats complexes, de conductivité électrique pouvant atteindre au moins 500 S/cm, voire 1000 S/cm, et avec une transmittance optique pouvant atteindre au moins 90% à 550 nm, voire 95% à 550 nm.

### Etape i)

L'étape i) étant effectuée par voie sèche, elle est mise en oeuvre sans solvant.

Au cours de l'étape i), une couche d'anode transparente conductrice comprenant du PEDOT dopé est déposée sur un substrat transparent non conducteur, par voie sèche oxydative.

La voie sèche oxydative peut être choisie parmi le dépôt chimique oxydatif en phase vapeur (également connu sous l'anglicisme « *oxidative Chemical Vapor Deposition* » ou oCVD) et le dépôt oxydatif d'une couche moléculaire (également connu sous l'anglicisme « *oxidative Molecular Layer Deposition* » ou oMLD).

Dans un mode de réalisation préféré, l'étape i) est effectuée à partir du monomère EDOT et d'au moins un agent oxydant, lesdits monomère EDOT et agent oxydant étant sous la forme de gaz.

L'agent oxydant peut être choisi parmi CuCl₂, FeCl₃, FeBr₃, I₂, POBr₃, GeCl₄, ShI₃, Br₂, SbF₅, SbCl₅, TiCl₄, POCl₃, SO₂Cl₂, CrO₂Cl₂, S₂Cl, O(CH₃)₃SbCl₆, VCl₄, MoCl₅, VOCl₃, BF₃, (CH₃(CH₂)₃)₂O.BF₃, (C₂H₅)₃O(BF₄), et BF₃.O(C₂H₅)₂.

FeCl₃, SbCl₅, et VOCl₃ sont préférés. En particulier, FeCl₃ présente une faible toxicité et un coût modeste.

Au cours de l'étape i), l'agent oxydant favorise la polymérisation du monomère EDOT et permet par la suite d'oxyder le polymère PEDOT neutre pour former le polymère PEDOT dopé.

Selon une forme de réalisation de l'invention, l'étape i) est effectuée dans un réacteur, en particulier équipé d'un porte-substrat.

Le réacteur peut être un réacteur à murs froids ou un réacteur à murs chauds, et de préférence un réacteur à murs chauds. Cela permet ainsi de favoriser la réalisation de dépôts uniformes sur des substrats de plus grande taille et de traiter des substrats non conducteurs thermiques tels que les matériaux polymères et les matériaux cellulosiques comme le papier.

Le porte-substrat peut être en un matériau choisi parmi les matériaux céramiques, les matériaux à base d'oxyde de silicium tels que le verre, ou le quartz, et les métaux tels que l'acier ou l'aluminium.

Dans le procédé de l'invention, le porte-substrat porte préférentiellement le substrat transparent non conducteur.

L'étape i) peut être effectuée à une température allant de 15°C environ à 190°C environ, et de préférence allant de 130°C environ à 180°C. Une température inférieure ou égale à 190°C permet de revêtir des substrats thermosensibles (papier, tissu, plastique, etc...).

L'étape i) peut être effectuée sous pression réduite, en particulier à une pression de gaz allant de 1.10⁻³ mbar à 1,5 mbar environ, et de préférence allant de 10⁻¹ mbar à 1 mbar environ.

Selon le procédé conforme au deuxième objet de l'invention, l'étape i) peut être effectuée en présence d'une quantité en mole N₁ dudit agent oxydant, et d'une quantité en mole N₂ dudit monomère EDOT.
Selon un mode de réalisation préféré, N₁ est strictement inférieure à N₂.

Selon un mode de réalisation particulièrement préféré, le rapport molaire N₁/N₂ va de 0,01 à 0,8 environ, et de façon plus particulièrement préférée de 0,05 à 0,1 environ.

L'étape i) peut durer de 1 min à 1 heure environ, et de préférence de 2 min à 30 min environ.

L'étape i) est de préférence réalisée à une vitesse allant de 0,2 à 30 nm.min⁻¹ environ.

L'étape i) peut comprendre les sous-étapes suivantes :
- une sous-étape i-1) au cours de laquelle on chauffe un ou plusieurs substrat(s) transparent(s) non conducteur(s) (préalablement déposé(s) sur le porte-substrat),
- une sous-étape i-2) d'alimentation du réacteur en EDOT gazeux, et
- une sous-étape i-3) d'alimentation du réacteur en agent oxydant gazeux.
Dès que les sous-étapes i-2) et i-3) sont initiées, l'EDOT polymérise en PEDOT

Entre les sous-étapes i-1) et i-2) ou les sous-étapes i-1) et i-3), le réacteur est préférentiellement purgé, en particulier en le mettant sous vide.

Lors de la sous-étape i-2), l'EDOT est de préférence transporté vers le réacteur en présence d'un gaz inerte tel que du diazote. Cela permet ainsi de diluer l'EDOT.

Lors de la sous-étape i-3), l'agent oxydant est de préférence transporté vers le réacteur en présence d'un gaz inerte tel que du diazote. Cela permet ainsi de diluer l'agent oxydant.

Lorsque l'étape i) est effectuée par oCVD, les réactifs EDOT et agent oxydant sont introduits en phase gazeuse en même temps ou simultanément dans le réacteur. Les sous-étapes i-2) et i-3) sont par conséquent concomitantes.

Lorsque l'étape i) est effectuée par oMLD, les réactifs EDOT et agent oxydant sont introduits en phase gazeuse de manière séquentielle ou alternée dans le réacteur. En d'autres termes, plusieurs sous-étapes i-2) et i-3) sont effectuées à la suite l'une de l'autre. De préférence, une sous-étape de purge au diazote est effectuée entre les sous-étapes i-2) et i-3) ou les sous-étapes i-3) et i-2). Cette sous-étape de purge permet d'éliminer les excès d'EDOT et d'agent oxydant, et tout produit volatil secondaire de la polymérisation.

Le flux gazeux d'EDOT peut aller de 1 à 10 cm³/min environ (en conditions standard de température et de pression), et de préférence de 2 à 6 cm³/min environ (en conditions standard de température et de pression).

Le flux gazeux d'agent oxydant peut aller de 0,2 à 3 cm³/min environ (en conditions standard de température et de pression), et de préférence de 0,5 à 1 cm³/min environ (en conditions standard de température et de pression).

Les sous-étape i-1) et i-2) [respectivement les sous-étape i-1) et i-3)] sont de préférence concomitantes.

La sous-étape i-1) est de préférence effectuée à une température allant de 15°C environ à 190°C environ, et de préférence allant de 130°C environ à 180°C environ.

### Etape ii)

Le procédé peut comprendre en outre une étape ii) de traitement acide après l'étape i). L'étape ii) peut permettre d'éliminer d'éventuels résidus d'agent oxydant et/ou d'augmenter le niveau de dopage du PEDOT pour améliorer sa conductivité électrique.

L'étape ii) peut comprendre la mise en contact du substrat transparent non conducteur revêtu de la couche d'anode transparente conductrice comprenant du PEDOT dopé formé à l'étape i), avec une solution comprenant un solvant organique polaire protique et au moins un acide fort.

L'acide fort peut être choisir parmi l'acide chlorhydrique, l'acide bromhydrique et l'acide sulfurique.

Le solvant organique polaire protique peut être un alcool en C₁-C₅, tel que le méthanol.

La mise en contact se fait préférentiellement en plongeant le substrat transparent non conducteur revêtu de la couche d'anode transparente conductrice comprenant du PEDOT dopé formé à l'étape i) dans ladite solution, par exemple pendant 15 à 60 min.

L'étape ii) peut comprendre en outre après la mise en contact avec la solution, le séchage du substrat transparent non conducteur revêtu de la couche d'anode transparente conductrice comprenant du PEDOT dopé sous air ou sous argon.

### Etape a)

Le procédé comprend en outre avant l'étape i), une étape a) au cours de laquelle le monomère EDOT et ledit agent oxydant sous la forme gazeuse sont préparés.

La préparation d'EDOT gazeux peut être effectuée en soumettant l'EDOT à une température allant d'au moins 70°C.

La préparation de l'agent oxydant gazeux peut être effectuée en soumettant l'agent oxydant à une température allant d'au moins 50°C.

### Etape b)

Le procédé comprend en outre avant l'étape i), une étape b) au cours de laquelle le substrat transparent non conducteur est nettoyé.

Le nettoyage du substrat transparent non conducteur a pour but d'éliminer les résidus organiques issus de la fabrication de celle-ci. L'étape b) favorise le bon fonctionnement de l'OLED (réduire la contamination, éliminer toutes aspérités sur la surface, etc...)

L'étape b) peut comprendre l'immersion dudit substrat transparent non conducteur dans un ou plusieurs solvants, en présence d'ultrasons.
Le solvant peut être de l'éthanol, de l'eau (de préférence déionisée), de l'isopropanol, et/ou de l'acétone

Lorsque le substrat transparent non conducteur est en verre, celui-ci peut par exemple être plongé successivement dans plusieurs bains sous ultra-sons : à savoir dans un bain d'eau déionisée (e.g. pendant 5 minutes), dans un bain d'acétone (e.g. pendant 5 minutes), puis dans un bain d'isopropanol (e.g. pendant 5 minutes).

Lorsque le substrat transparent non conducteur est en matière plastique, celui-ci peut par exemple être plongé successivement dans plusieurs bains sous ultra-sons : à savoir dans un bain d'eau déionisée (e.g. pendant 5 minutes), dans un bain d'éthanol (e.g. pendant 5 minutes), puis dans un bain d'isopropanol (e.g. pendant 5 minutes).

L'étape b) peut comprendre en outre après l'immersion, un traitement UV-Ozone, par exemple pendant 10 min, de préférence suivi d'un séchage du substrat transparent non conducteur sous atmosphère inerte, en particulier sous gaz inerte d'argon ou d'azote

### Etape iii)

Le procédé peut comprendre en outre après l'étape i) ou ii), une étape iii) de dépôt du système électroluminescent organique.

L'étape iii) est de préférence effectuée sous atmosphère inerte, et en particulier sous atmosphère d'azote.

L'étape iii) peut être effectuée par évaporation thermique.

L'étape iii) est de préférence réalisée sous vide, notamment à une pression inférieure à 10⁻⁵ mbar environ.

L'étape iii) est de préférence réalisée à une vitesse allant de 0,1 à 0,2 nm.s⁻¹ environ.

Un masque peut être utilisée pendant l'étape iii) pour obtenir une ou plusieurs couches électroluminescentes organiques ayant la forme et/ou la surface souhaitée.

Lorsque le système électroluminescent organique est multicouche, le procédé comprend plusieurs étapes iii-1), iii-2), etc... selon le nombre de couches électroluminescentes organiques à déposer, chacune des étapes iii-1), iii-2) etc... étant similaire à l'étape iii) telle que définie dans l'invention.

Dans un mode de réalisation préféré, le procédé comprend après l'étape i) ou ii, une étape iii-1) de dépôt d'une couche de transport de trous, suivie d'une étape iii-2) de dépôt d'une couche de transport d'électrons.

### Etape iv)

Le procédé peut comprendre en outre après l'étape iii), une étape iv) de dépôt de la couche de cathode.

L'étape iv) est de préférence effectuée sous atmosphère inerte, et en particulier sous atmosphère d'azote.

L'étape iv) peut être effectuée par évaporation thermique.

L'étape iv) est de préférence réalisée sous vide, notamment à une pression inférieure à 10⁻⁵ mbar environ.

L'étape iv) est de préférence réalisée à une vitesse allant de 0,05 à 0,1 nm.s⁻¹ environ.

Un masque peut être utilisée pendant l'étape iv) pour obtenir une couche de cathode ayant la forme et/ou la surface souhaitée.

Dans la diode électroluminescente organique de l'invention, la couche comprenant du PEDOT dopé monophasique ou obtenu par voie sèche oxydative, est utilisée en tant qu'électrode, et en particulier en tant qu'anode (transparente conductrice).

L'invention a pour quatrième objet l'utilisation d'une diode électroluminescente organique conforme au premier objet ou d'un dispositif optoélectronique conforme au deuxième objet, comme moyen d'authentification (e.g . signature particulière, marquage évident ou marquage non évident), ou de décoration.

Comme moyen d'authentification, il peut être utilisé :
- pour marquer des emballages dans le domaine de l'agroalimentaire, notamment lorsque le substrat transparent non conducteur est en matière plastique, ou
- pour résoudre des problèmes de falsification et de contrefaçon de pièces de paiement et de documents officiels, par exemple en marquant des papiers de sécurité.

Comme moyen de décoration, la diode électroluminescente organique ou le dispositif optoélectronique peut être utilisé dans le domaine du luxe, notamment pour décorer des tissus.

La diode électroluminescente organique ou le dispositif optoélectronique peut être utilisé dans le domaine de la santé, par exemple pour produire un bandage luminescent activant des molécules photosensibles pour des traitements médicaux.

### Brève description des dessins

Les dessins annexés illustre l'invention.
La figure 1 représente les différentes couches d'une diode électroluminescente organique et d'un dispositif optoélectronique selon l'invention.
La figure 2 représente le réacteur mis en oeuvre selon le procédé de l'invention.
La figure 3 représente les propriétés de luminance d'une diode électroluminescente organique selon l'invention.
La figure 4 représente les propriétés de luminance d'une diode électroluminescente organique selon l'invention et d'une diode électroluminescente organique non conforme à l'invention.
La figure 5 représente les propriétés de luminance d'une diode électroluminescente organique selon l'invention et d'une diode électroluminescente organique non conforme à l'invention.
La figure 6 représente les propriétés de luminance d'une diode électroluminescente organique selon l'invention et d'une diode électroluminescente organique non conforme à l'invention.

D'autres caractéristiques et avantages de la présente invention apparaîtront à la lumière de la description d'exemples non limitatifs de la diode organique électroluminescente selon l'invention, ainsi que de son procédé de fabrication.

### Exemples

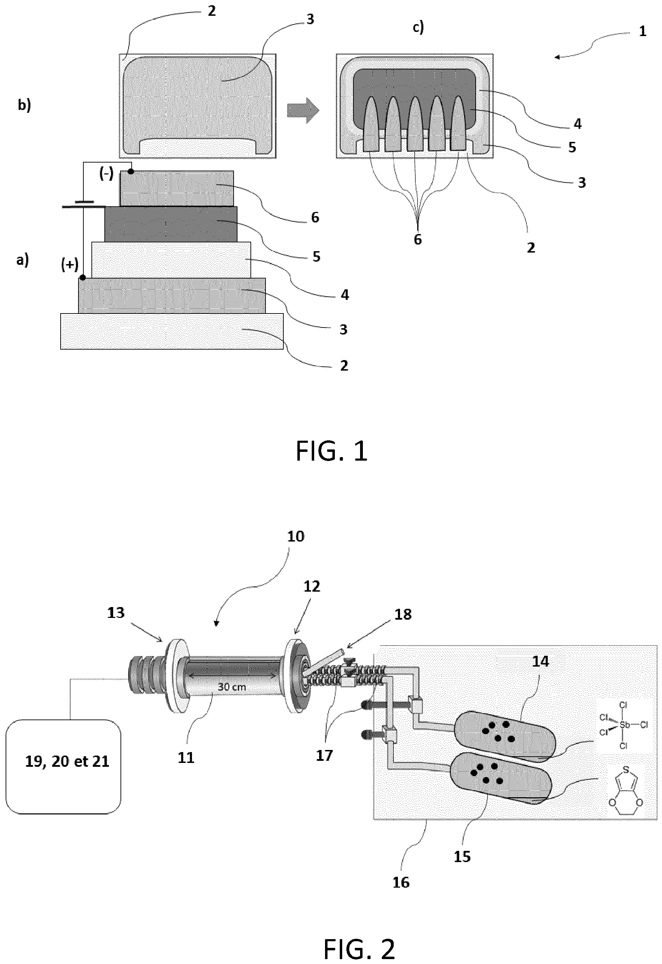

La figure 1 représente plusieurs schémas de l'empilement d'une OLED conforme à l'invention, à émission de la lumière vers le bas. En particulier, la figure 1 a représente une diode organique électroluminescente conforme au premier objet de l'invention comprenant successivement, dans l'ordre suivant :
- un substrat transparent non conducteur **2,** tel qu'un substrat en verre ou en plastique (par exemple d'épaisseur 1-2 mm),
- une couche d'anode transparente conductrice **3** comprenant du PEDOT dopé monophasique ou du PEDOT dopé obtenu par voie sèche oxydative (par exemple d'épaisseur 34 nm),
- un système électroluminescent organique **(4, 5),** et
- une couche de cathode **6** telle qu'une couche de calcium (par exemple d'épaisseur 80 nm).

Le système électroluminescent organique comprend en particulier une couche de transport de trous **4** telle qu'une couche de NPD (par exemple d'épaisseur 55 nm), et une couche de transport d'électrons **5** telle qu'une couche de AlQ₃ (par exemple d'épaisseur 85 nm).

La figure 1 b représente la couche d'anode transparente conductrice **3** comprenant du PEDOT dopé monophasique ou du PEDOT dopé obtenu par voie sèche oxydative, qui a été déposée sur le substrat transparent non conducteur **2.**

La figure 1 c représente un dispositif optoélectronique **1** composé de cinq diodes électroluminescentes organiques selon l'invention. Le dispositif comprend en particulier, successivement, dans l'ordre suivant :
- un substrat transparent non conducteur **2,** tel qu'un substrat en verre ou en plastique (par exemple d'épaisseur 1-2 mm),
- une couche d'anode transparente conductrice **3** comprenant du PEDOT dopé monophasique ou du PEDOT dopé obtenu par voie sèche oxydative (par exemple d'épaisseur 34 nm),
- un système électroluminescent organique **(4, 5),** et
- cinq couches de cathode **6** telles que des couches de calcium (par exemple d'épaisseur 80 nm) sur un même plan, qui est parallèle au plan formé par le système électroluminescent organique **(4, 5).**

Le système électroluminescent organique comprend en particulier une couche de transport de trous **4** telle qu'une couche de NPD (par exemple d'épaisseur 55 nm), et une couche de transport d'électrons **5** telle qu'une couche de AlQ₃ (par exemple d'épaisseur 85 nm).

Le substrat transparent non conducteur **2,** la couche d'anode transparente conductrice **3** comprenant du PEDOT dopé monophasique ou du PEDOT dopé obtenu par voie sèche oxydative, et le système électroluminescent organique **(4, 5)** sont communs aux cinq diodes, et chacune des diodes électroluminescentes organiques a sa propre couche de cathode **6.**

La taille du substrat transparent non conducteur **2** (en verre ou en plastique) peut être de 24 x 36 cm². Dans le dispositif **1,** le substrat transparent non conducteur **2** peut accueillir jusqu'à cinq OLEDs, i.e. cinq couches de cathode **6.** La surface émissive de chaque OLED est de 0,20 cm².

### Exemple 1 : procédé de fabrication d'une OLED conforme à l'invention et selon un procédé conforme à l'invention

### Préparation de la couche de PEDOT dopé obtenue par voie sèche oxydative

La figure 2 est une représentation schématique du réacteur **10** d'oCVD de dépôt de la couche de PEDOT dopé utilisé dans le procédé de l'invention. Le réacteur **10** comprend un tube en verre borosilicaté de 4,9 cm de diamètre et de 32 cm de long (30 cm de longueur utile), entouré par un manteau chauffant **11** et relié à ses deux extrémités à des brides en acier de référence « KF50 » qui permettent de connecter des tubes d'entrée **12** et de sortie **13** de gaz. Chaque bride est chauffée par un ruban chauffant. Il s'agit donc d'un réacteur à murs chauds. Un thermocouple est placé sur la paroi externe du réacteur, à 15 cm de l'entrée du tube en verre et relié à un régulateur PID (proportionnel, intégral, dérivé) pour contrôler la température du manteau chauffant.

Du côté de l'entrée **12** du réacteur, les deux réactifs liquides à l'état ambiant, l'oxydant (SbCl₅) et le monomère (EDOT), sont placés chacun dans un réservoir en verre **(14, 15)** respectivement, connecté à une vanne micrométrique et à une vanne quart de tour par le biais de tubes en acier inox. L'ensemble réservoirs + tubes inox + vannes micrométriques est placé dans un fourthermostaté **16** pour contrôler au mieux la vaporisation des deux réactifs et le débit de vapeur envoyé au réacteur. Les tubes en acier inox et les vannes quart de tour sont thermostatés par des rubans chauffants **17** pour éviter toute re-condensation des vapeurs de réactifs. Ces rubans chauffants **17** traversent la cloison du four épaisse de quelques centimètres, pour qu'il n'y ait pas de point froid. Une ligne d'azote de dilution **18,** thermostatée par un ruban chauffant, est aussi présente à l'entrée **12** du réacteur.

Du côté de la sortie **13** du réacteur, le tube en acier est lui aussi thermostaté par un ruban chauffant, puis connecté à une vanne papillon asservie à un système électronique de contrôle de la pression **19** et à un capteur de pression **20** (« *MKS Baratron capacitance manometer* » ; 100 mbar). Un piège à azote liquide est placé avant la pompe à vide **21.**

Au total 7 rubans chauffants et 1 manteau chauffant sont présents sur l'installation. Chacun est relié à une électronique de commande et la température des lignes de gaz ou des brides est contrôlée précisément par des thermocouples soit fixés *in situ,* soit flottants, que l'on déplace à la demande.

Le profil de température à l'intérieur du réacteur est mesuré par une procédure spécifique, en dehors de toute expérience de dépôt, en utilisant un thermocouple placé dans le réacteur et déplacé tout le long du tube en verre borosilicaté.

Un porte-substrat, constitué d'une plaque en verre de 30 cm de long, 4,2 cm de large et 2 mm d'épaisseur, permet de positionner horizontalement différents substrats à revêtir tout le long du réacteur.

L'étape i) du procédé de l'invention est mise en oeuvre avec les conditions répertoriées dans le tableau 1 ci-dessous.

**TABLEAU 1**

| | |
|---|---|
| Température du four **16** contenant les deux réservoirs | 90°C |
| Température des rubans chauffants à l'entrée du réacteur **12** | 150°C |
| Température de la ligne de N₂ **18** | 110°C |
| Température des rubans chauffants à la sortie du réacteur **13** | 165°C |
| Volume de réactif initialement placé dans chaque réservoir **14 et 15** | 2 cm³ |
| Débit d'EDOT gazeux | 2,9 cm³/min (aux température et pression standard) |
| Débit de SbCl₅ gazeux | 0,9 cm³/min (aux température et pression standard) |
| Débit de N₂ | 30 cm³/min (aux température et pression standard) |
| Durée des dépôts | 5-8 min |
| Température de consigne du manteau chauffant | 150 °C |
| Température du substrat transparent non conducteur | 145°C |
| Pression à l'intérieur du réacteur | 40 Pa |

On obtient ainsi une couche de PEDOT dopé avec des anions chlorures monophasique ayant une épaisseur contrôlable et uniforme sur plusieurs dizaines de cm².

### Préparation des autres couches

Le substrat **2** recouvert de la couche de PEDOT dopé **3** est ensuite transféré en boîte à gants (sous atmosphère d'azote). Les couches de transport de trous **4** et d'électrons **5** sont déposées au sein d'un évaporateur « *Boc Edwards Auto 500* »*,* placé en boîte à gants, et contenant deux sources basses températures (« Edwards ») et des capteurs à quartz (« Inficon, modèle 103220 ») de 6 MHz en or.

Les composés organiques utilisés NPD et AlQ₃ sont sous forme de poudre et sont sublimés (à une température < 300°C) à l'aide d'un creuset. L'association NPD/AlQ₃ permet d'avoir une émission à 550 nm dans le vert. Un masque ayant une forme appropriée est placé entre les sources thermiques et le porte-échantillon. Le masque permet de définir la surface de la couche de transport de trous **4** et de la couche de transport d'électrons **5.** Le dépôt des couches **4** et **5** est réalisé sous un vide inférieur à 10⁻⁵ mbar à une vitesse de dépôt de 0,1-0,2 nm.s⁻¹. L'épaisseur des couches est contrôlée par des capteurs à quartz.

En remplaçant AlQ₃ par TPBi dans les mêmes conditions de dépôt, l'association NPD/TPBi permet d'avoir une émission à 435 nm dans le bleue.

Une couche de cathode composée de calcium **6** est ensuite déposée par évaporation thermique à travers un masque dans la même enceinte. Le calcium est évaporé à 575°C avec une vitesse de dépôt de 0,05-0,1 nm.s⁻¹. La couche de cathode **6** est réalisée sous forme de peigne afin d'avoir une surface d'éclairage la plus homogène possible. Sur un même substrat, cinq OLEDs peuvent être fabriquées, notamment en ajoutant des couches de cathode. La surface émissive des OLEDs est définie par la taille des couches de cathodes, qui est de 0,2 cm².

### Exemple 2 : performances de trois OLEDs conformes à l'invention

Les caractérisations électriques sont réalisées à l'aide d'un sourcemètre (« Keithley »), en reliant la borne positive de ce dernier à la couche d'anode et sa borne négative à la couche de cathode. Les mesures sont réalisées en boîte à gants, sous atmosphère contrôlée (diazote) pour s'affranchir de toutes dégradations liées à l'oxygène et l'eau ambiants. Les caractéristiques optiques des OLEDs (les luminances et les spectres d'électroluminescence) sont mesurées à l'aide d'un spectroradiomètre (« SpecBos »). Les mesures lumineuses sont effectuées en boîte à gants, dans l'obscurité afin que le spectroradiomètre ne soit pas perturbé par la lumière environnante.

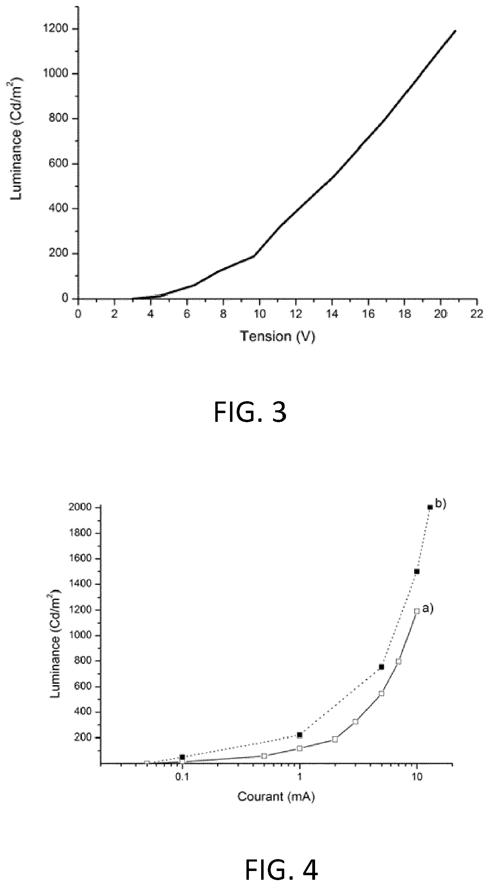

La figure 3 montre la luminance (en cd/m²) en fonction de la tension (en V) d'une diode électroluminescente organique **D₁** conforme à l'invention telle que représentée sur la figure 1 a avec un substrat en verre et émettant dans le vert (association NPD/AlQ₃). L'OLED de l'invention démontre un potentiel lumineux, avec une luminance maximum de 1200 Cd/m².

La figure 4 montre la luminance (en cd/m²) en fonction du courant (en mA) de la diode électroluminescente organique **D₁** conforme à l'invention telle que représentée dans la figure 1 a avec un substrat en verre [courbe a)] et détaillée ci-dessus pour la figure 3 ; et à titre comparatif d'une diode électroluminescente organique **D_{A}** non conforme à l'invention dans laquelle la couche de PEDOT dopé de 34 nm d'épaisseur est remplacée par une couche de ITO de 150 nm d'épaisseur déposée par pulvérisation cathodique [courbe b)]. L'OLED de l'invention démontre un potentiel lumineux, avec une luminance maximum de 1200 Cd/m² qui approche celle de la diode comparative à base d'ITO. Cela permet de démontrer que la couche comprenant du PEDOT dopé monophasique ou obtenu par voie sèche oxydative, peut être utilisée en tant qu'électrode, et en particulier en tant qu'anode (transparente conductrice), dans une diode électroluminescente organique, tout en garantissant de bonnes performances.

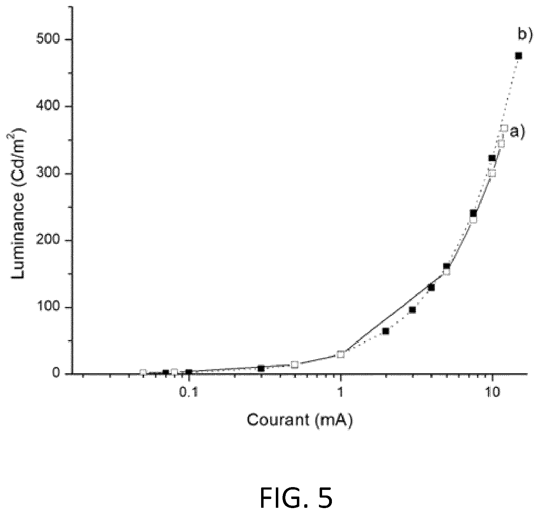

La figure 5 montre la luminance (en cd/m²) en fonction du courant (en mA) d'une diode électroluminescente organique **D₂** conforme à l'invention telle que représentée dans la figure 1 a avec un substrat en verre [courbe a)] et émettant dans le bleu (association NPD/TPBi au lieu de NPD/AlQ³) ; et à titre comparatif d'une diode électroluminescente organique **D_{A}** non conforme à l'invention et détaillée ci-dessus pour la figure 4 [courbe b)]. L'OLED de l'invention démontre un potentiel lumineux, avec une luminance maximum de 300 Cd/m² qui approche celle de la diode comparative à base d'ITO. Cela permet de démontrer que la couche comprenant du PEDOT dopé monophasique ou obtenu par voie sèche oxydative, peut être utilisée en tant qu'électrode, et en particulier en tant qu'anode (transparente conductrice), dans une diode électroluminescente organique, tout en garantissant de bonnes performances.

Les performances obtenues présentent par exemple un intérêt pour des applications dans le domaine de l'éclairage d'ambiance ou des dispositifs d'affichage décoratifs ou de signalisation qui ne nécessitent pas des luminances élevées (quelques centaines de Cd/m²).

Les caractéristiques des deux diodes fabriquées **D₁** et **D₂** sont répertoriées dans les tableaux 2 et 3 ci-dessous.

**TABLEAU 2**

| Diode | Courant (mA) | Tension (V) | Luminance (Cd/m²) | Conductivité (S/m) | Rugosité (en nm, RMS) | Transmittance (%) à 550 nm |
|---|---|---|---|---|---|---|
| **D₁** | 10 | 21 | 1200 | 560 | 1 | 84 |
| **D_{A}** | 10 | 15 | 1450 | 6700 | 5 | 84 |

**TABLEAU 3**

| Diode | Courant (mA) | Tension (V) | Luminance (Cd/m²) | Conductivité (S/m) | Rugosité (en nm, RMS) | Transmittance (%) à 435 nm |
|---|---|---|---|---|---|---|
| **D₂** | 10 | 22 | 300 | 560 | 1 | 89 |
| **D_{A}** | 10 | 8 | 322 | 6700 | 5 | 80 |

*A contrario,* la diode comparative comprenant de l'ITO présente de nombreux inconvénients :
- les OLEDs comprenant une couche d'anode d'ITO déposée sur un substrat plastique ne peuvent que difficilement être élaborées en raison de la faible tenue mécanique de la couche d'ITO sur les substrats plastiques. Une couche d'accroche est alors nécessaire, ce qui n'est pas le cas de la couche d'anode de PEDOT dopé de la diode de l'invention qui peut être déposée sur tout type de substrat.
- le protocole de dépôt (par pulvérisation cathodique) de l'ITO doit être réalisé à basse température en raison de la faible température de transition vitreuse des substrats plastiques (Tg< 200°C), ce qui a pour conséquence :
   * une plus forte rugosité de surface de la couche d'ITO,
   * une faible souplesse de la couche d'ITO déposée sur un substrat souple de type PET (polytéréphtalate d'éthylène) : formation de microfissures à la surface de la couche d'ITO sous contraintes mécaniques,
   * une perte de ses propriétés électriques (plus grande résistance de surface) par rapport à une couche d'ITO déposée sur un substrat de verre,
   * des propriétés de luminance réduites : pour une OLED avec une couche d'ITO déposée sur un substrat plastique, on peut observer une perte jusqu'à 40% de la luminance par rapport celle obtenue avec une OLED déposée sur un substrat de verre (pour une même densité de courant et pour une même structure de l'OLED).

Par ailleurs, une couche d'ITO de 34 nm (i.e. de même épaisseur que la couche de PEDOT dopé de l'invention) sera très faiblement voire pas conductrice. La diode correspondante présentera donc une luminance également faible.

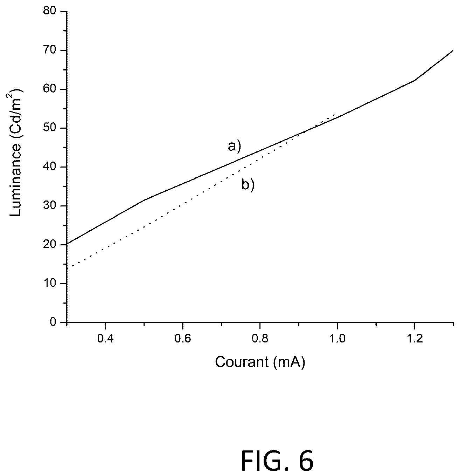

La figure 6 montre la luminance (en cd/m2) en fonction du courant (en mA) de d'une diode électroluminescente organique **D₃** conforme à l'invention telle que représentée dans la figure 1 a avec un substrat flexible à base de polyméthacrylate de méthyle (PMMA) [courbe a)] et émettant dans le vert (NPD associé à un matériau organique/AlQ₃) ; et à titre comparatif d'une diode électroluminescente organique **D_{C}** non conforme à l'invention dans laquelle la couche de PEDOT dopé est remplacée par une couche d'ITO déposée par pulvérisation cathodique [courbe b)] avec un substrat de verre. Le dépôt d'une couche d'anode d'ITO sur substrat plastique et flexible tel que le polyméthacrylate de méthyle est rendu difficile en raison de la faible tenue mécanique de la couche d'ITO sur un tel substrat et de la non compatibilité des conditions de dépôts de l'ITO avec les propriétés thermiques du substrat de PMMA (recuit post dépôt à une température de 400°C, supérieure à la température de dégradation du PMMA). L'OLED **D₃** de l'invention a donc été comparée à une OLED **D_{C}** non conforme comportant 2 différences par rapport à l'OLED **D₃ :** couche d'ITO (vs couche PEDOT pour **D₃)** et substrat de verre (vs substrat PMMA pour **D₃**). L'OLED de l'invention démontre un potentiel lumineux, avec une luminance maximum de 70 Cd/m² qui approche celle de la diode comparative à base d'ITO. Cela permet de démontrer que la couche comprenant du PEDOT dopé monophasique ou obtenu par voie sèche oxydative, peut être utilisée en tant qu'électrode, et en particulier en tant qu'anode (transparente conductrice) sur substrat plastique et flexible, dans une diode électroluminescente organique, tout en garantissant des performances acceptables.

## Revendications

1. Diode électroluminescente organique, **caractérisée en ce qu'**elle comprend, successivement, dans l'ordre suivant :
- un substrat transparent non conducteur (2),
- une couche d'anode transparente conductrice (3) comprenant du PEDOT dopé monophasique ou du PEDOT dopé obtenu par voie sèche oxydative,
- un système électroluminescent organique (4, 5) émettant de la lumière dans la gamme de longueurs d'onde allant de 380 à 800 nm, en réponse à un courant électrique qui le traverse ou à un champ électrique, et
- une couche de cathode (6).

2. Diode selon la revendication 1, **caractérisée en ce que** le PEDOT est dopé avec des anions choisis parmi les halogénures.

3. Diode selon la revendication 1 ou 2, **caractérisée en ce que** la couche d'anode (3) a une épaisseur allant de 8 à 80 nm.

4. Diode selon l'une quelconque des revendications précédentes, **caractérisée en ce que** le PEDOT dopé de la couche d'anode transparente conductrice (3) est obtenu à partir du monomère EDOT et d'au moins un agent oxydant, lesdits monomère EDOT et agent oxydant étant des espèces gazeuses.

5. Diode selon l'une quelconque des revendications précédentes, **caractérisée en ce que** le substrat transparent non conducteur (2) est au moins en partie en contact physique direct avec la couche d'anode transparente conductrice (3).

6. Diode selon l'une quelconque des revendications précédentes, **caractérisée en ce que** le substrat transparent non conducteur (2) comprend un matériau choisi parmi les matériaux inorganiques à base d'oxyde de silicium, les matériaux inorganiques à base d'alumine, les matériaux polymères, les matériaux cellulosiques, et les matières textiles.

7. Diode selon l'une quelconque des revendications précédentes, **caractérisée en ce que** le système électroluminescent organique (4, 5) est multicouche et comprend :
- au moins une couche de transport de trous (4) ; et
- au moins une couche de transport d'électrons (5).

8. Diode selon la revendication 7, **caractérisée en ce que** la couche de transport de trous (4) est au moins en partie en contact physique direct avec la couche d'anode transparente conductrice (3) comprenant du PEDOT dopé monophasique ou du PEDOT dopé obtenu par voie sèche oxydative ; et la couche de transport d'électrons (5) est au moins en partie en contact physique direct avec la couche de cathode (6).

9. Diode selon l'une quelconque des revendications précédentes, **caractérisée en ce que** la couche de cathode (6) comprend un métal choisi parmi le baryum, l'argent, le magnésium, le calcium, l'aluminium, et l'aluminium associé à une couche de fluorure de lithium.

10. Dispositif optoélectronique (1), **caractérisé en ce qu'**il comprend une pluralité de diodes électroluminescentes organiques, au moins une des diodes électroluminescentes organiques de ladite pluralité étant telle que définie à l'une quelconque des revendications précédentes.

11. Procédé de fabrication d'une diode électroluminescente telle que définie à l'une quelconque des revendications 1 à 9, **caractérisé en ce qu'**il comprend au moins une étape i) de dépôt d'une couche d'anode transparente conductrice (3) comprenant du PEDOT dopé sur un substrat transparent non conducteur (2), ladite étape i) étant effectuée par voie sèche oxydative.

12. Procédé selon la revendication 11, **caractérisé en ce que** la voie sèche oxydative est choisie parmi le dépôt chimique oxydatif en phase vapeur et le dépôt oxydatif d'une couche moléculaire.

13. Procédé selon la revendication 11 ou 12, **caractérisé en ce que** l'étape i) est effectuée dans un réacteur à murs chauds (10).

14. Utilisation d'une diode électroluminescente organique telle que définie à l'une quelconque des revendications 1 à 9 ou d'un dispositif optoélectronique (1) tel que défini à la revendication 10, comme moyen d'authentification, ou de décoration.
